# EUROPÄISCHE PATENTSCHRIFT

(11) **EP 1 521 091 B1**
(45) Veröffentlichungstag und Bekanntmachung des Hinweises auf die Patenterteilung: **20.02.2008**
(21) Anmeldenummer: 04016920.3
(22) Anmeldetag: 17.07.2004
(51) Int. Cl.: G01R 31/00, B60R 16/02

(54) **Überwachung der Bordnetz-Leistungsfähigkeit**
Monitoring of power supply network
Surveillance de circuit de tableau de bord

(30) Priorität: 30.09.2003 DE 10345305
(43) Veröffentlichungstag der Anmeldung: 06.04.2005
(73) Patentinhaber: ROBERT BOSCH GMBH, 70442 Stuttgart (DE)
(72) Erfinder: Knapp, Marc, 71729 Erdmannhausen (DE)

(56) Entgegenhaltungen:
- DE-A1- 10 142 085
- DE-B- 10 309 913
- US-A1- 2001 054 890

## Beschreibung

Die Erfindung betrifft eine Vorrichtung zum Überwachen der Leistungsfähigkeit eines elektrischen Bordnetzes gemäß dem Oberbegriff des Patentanspruchs 1 sowie ein entsprechendes Verfahren gemäß dem Oberbegriff des Patentanspruchs 8.

In heutigen Kfz-Bordnetzen werden immer mehr sicherheitsrelevante Verbraucher, wie z.B. elektrisch unterstützte Lenksysteme oder elektrisch betätigte Feststellbremsen eingesetzt, deren elektrische Versorgung sichergestellt sein muss. Durch eine Überwachung der Leistungsfähigkeit des elektrischen Netzes soll insbesondere ein bevorstehender Ausfall dieser Verbraucher rechtzeitig erkannt und verhindert werden.

Elektrisch betätigte Feststellbremsen umfassen ein Bedienelement, wie z.B. einen Druckknopf, zum Betätigen der Feststellbremse. Ein mit dem Bedienelement verbundenes Steuergerät erkennt den Feststellbremswunsch und steuert entsprechend einen Aktuator, wie z.B. einen Elektromotor oder ein Hydraulikpumpe, an, um die Feststellbremse anzuziehen oder zu lösen.

Gemäß den gesetzlichen Vorschriften muss das Fahrzeug bei angezogener Feststellbremse mechanisch und energielos festgehalten werden. Eine Feststellbremse umfasst daher üblicherweise eine mechanische Verriegelungseinrichtung, die die Bremszangen in der angezogenen Stellung verriegelt. Die Verriegelungseinrichtung wird in der Regel ebenfalls durch hydraulischen bzw. pneumatischen Druck betätigt. Hierzu werden eine Hydraulikpumpe und Magnetventile elektrisch angesteuert.

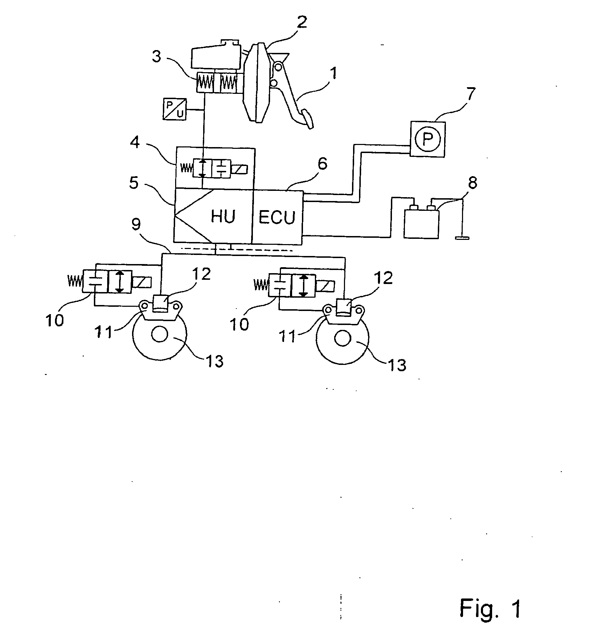

Fig. 1 zeigt ein aus dem Stand der Technik bekanntes Feststellbremssystem in schematischer Darstellung. Die Feststellbremse umfasst im wesentlichen ein Betätigungselement 7 (Druckknopf), ein Steuergerät 6 und ein Hydroaggregat 5. Bei einer Betätigung des Bedienelements 7 steuert das Steuergerät 6 das Hydroaggregat 5 bzw. eine Hydraulikpumpe an, die in einer Hydraulikleitung 9 Druck erzeugt, der sowohl zum Betätigen der Radbremse 11 als auch zum Betätigen der Verriegelungseinrichtung 12 genutzt wird. Die Feststellbremse umfasst ferner ein Hydraulikventil 10, das vom Steuergerät 6 angesteuert wird, um die Verriegelungseinrichtung 12 zu verriegeln bzw. zu lösen.

Das Feststellbremssystem wird aus dem Bordnetz von einer Batterie 8 mit Strom versorgt. Bei einem Ausfall der elektrischen Energieversorgung ist es nicht mehr möglich, die Feststellbremse zu verriegeln (um zum Beispiel das Fahrzeug sicher abzustellen) oder die Feststellbremse bei geparktem Fahrzeug zu lösen (um es beispielsweise abzuschleppen), da das Ventil 10 und die Hydraulikpumpe 5 nicht mehr angesteuert werden können. Es besteht somit die Gefahr, dass die Feststellbremse aus Energiemangel nicht ausreichend stark angezogen wird oder nicht verriegelt und das Fahrzeug unbeabsichtigt anrollt.

Aus der gattungsgemäßer US 2001/0054890 A1 sind Verfahren und Vorrichtungen zur Prüfung der Funktionsfähigkeit eines Generators, der Bestandteil eines Fahrzeugbordnetzes ist, bekannt, bei denen die Welligkeit der Ausgangsspannung des Generators ermittelt und mit Schwellwerten verglichen wird. Mangelnde Funktionsfähigkeit des Generators wird erkannt, wenn die Frequenz oder die Amplitude der Welligkeit der Ausgangsspannung die Schwellwerte überschreitet. Zur Erhöhung der Zuverlässigkeit der Erkennung der Funktionsfähigkeit des Generators wird die Spannungswelligkeit auch bei mit einem mit einem starken Verbraucher belasteten Generator ausgewertet. Die Reaktion auf das Zuschalten des Verbrauchers wird jedoch nicht ausgewertet.

Es ist daher die Aufgabe der vorliegenden Erfindung, die Leistungsfähigkeit des elektrischen Bordnetzes in einfacher Weise zu überwachen, um eine drohende Fehlfunktion eines elektrischen Verbrauchers, insbesondere einer elektrisch betätigten Feststellbremse rechtzeitig zu erkennen und den Fahrer entsprechend zu informieren.

Gelöst wird diese Aufgabe gemäß der Erfindung durch die im Patentanspruch 1 sowie im Patentanspruch 8 angegebenen Merkmale. Weitere Ausgestaltungen der Erfindung sind Gegenstand von Unteransprüchen.

Ein wesentlicher Aspekt der Erfindung besteht darin, sowohl die Bordnetzspannung als auch die Welligkeit der Bordnetzspannung mittels einer geeigneten Elektronik auszuwerten, daraus die Leistungsfähigkeit des Bordnetzes abzuschätzen und bei Feststellung eines schwachen Bordnetzes ein Warnmeldung an den Fahrer auszugeben. Die Bordnetzspannung als auch die Welligkeit der Bordnetzspannung werden vorzugsweise in einem Steuergerät ausgewertet und überwacht. Dies hat den Vorteil, dass eine separate Sensorik zur Überprüfung des Batteriezustands (Batteriezustandserkennung) nicht erforderlich ist. Darüber hinaus kann die Leistungsfähigkeit des Bordnetzes in einfacher Weise und kostengünstig ermittelt werden.

Die Auswerteelektronik, die vorzugsweise als Steuergerät realisiert ist, führt vorzugsweise einen Schwellenwertvergleich durch, bei dem die Bordnetzspannung bzw. die Welligkeit mit vorgegebenen Schwellenwerten verglichen werden. Sinkt beispielsweise die Bordnetzspannung beim Zuschalten eines großen Verbrauchers, wie z.B. beim Anlaufen der Hydraulikpumpe, unter einen vorgegebenen Schwellenwert (z.B. 11,5V), so ist dies ein Hinweis auf ein schwaches Bordnetz. Die Spannungsfestigkeit des Bordnetzes wird vorzugsweise mehrere Male überprüft, bevor ein "schwaches Bordnetz" diagnostiziert wird.

Auch die Amplitude der Welligkeit gibt einen Aufschluss über die Leistungsfähigkeit des Bordnetzes. Bei defekter Batterie ist die Amplitude der Spannungswelligkeit wegen der fehlenden Puffer- bzw. Filterwirkung der Batterie wesentlich höher als bei intakter Batterie. Somit kann über die Auswertung der Amplitude der Zustand des Bordnetzes abgeschätzt werden.

Wahlweise kann auch die Frequenz der Welligkeit ausgewertet werden. Auch die Welligkeit kann vor einer Entscheidung über den Bordnetzzustand mehrere Male ausgewertet werden, um eine Fehlbestimmung des Bordnetzzustandes aufgrund von Störungen auszuschließen.

Zur Signalverarbeitung und Auswertung werden vorzugsweise Filterschaltungen eingesetzt. Die entsprechenden Funktionen zur Signalverarbeitung sind vorzugsweise im Steuergerät in Form eines Algorithmus implementiert.

Gemäß einer speziellen Ausführungsform der Erfindung wird zunächst die Reaktion der Bordnetzspannung auf das Zuschalten eines großen elektrischen Verbrauchers, und in einem weiteren Schritt die Welligkeit der Bordnetzspannung ausgewertet. Aus dem Resultat der Auswertung wird dann die Leistungsfähigkeit des Bordnetzes abgeschätzt.

Gemäß einer bevorzugten Ausführungsform der Erfindung wird die Leistungsfähigkeit des Bordnetzes mehrere Male überprüft, bevor eine Warnmeldung generiert wird.

Außerdem wird vorzugsweise die Temperatur bei der Abschätzung der Leistungsfähigkeit des Bordnetzes berücksichtigt. Dies kann beispielsweise dadurch realisiert sein, dass die Schwellenwerte für die Bordnetzspannung und/oder die Welligkeit temperaturabhängig gewählt werden.

Um die Funktion einer Feststellbremse auch bei unzureichender Energieversorgung sicherzustellen, ist das Feststellbremssystem vorzugsweise derart eingerichtet, dass die Feststellbremse durch Betätigen des Fuß-Bremspedals unterstützt werden kann. Bei schwachem Bordnetz wird der Fahrer daher vorzugsweise zur Unterstützung der Feststellbremse aufgefordert.

Die Erfindung wird nachstehend anhand der beigefügten Zeichnungen beispielhaft näher erläutert. Es zeigen:
Fig. 1 eine schematische Darstellung einer elektrisch angesteuerten Feststellbremse gemäß dem Stand der Technik;
Fig. 2 ein Prinzipschaltbild einer elektrischen Feststellbremse; und
Fig. 3 ein Zustandsdiagramm zur Beschreibung der Funktion einer Feststellbremse gemäß einer Ausführungsform der Erfindung.

Bezüglich der Erläuterung von Fig. 1 wird auf die Beschreibungseinleitung verwiesen.

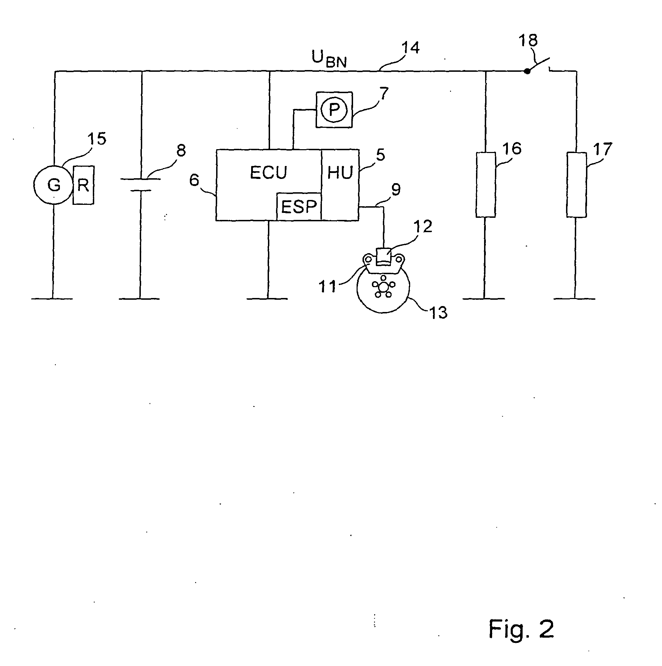

Fig. 2 zeigt eine vereinfachte Darstellung eines Kfz-Bordnetzes 14, das von einem Generator 15 und einer Batterie 8 mit elektrischer Energie versorgt wird. Die Batterie 8 wird bei laufendem Motor vom Generator 15 aufgeladen.

Das Bordnetz umfasst verschiedene Verbraucher, die hier exemplarisch als ein Verbraucher 16 bzw. 17 dargestellt sind. Die Verbraucher 17 können mittels eines Schalters 18 auf Anforderung ab- oder zugeschaltet werden.

Das elektrische Bordnetz 14 umfasst ferner ein Steuergerät 6, in dem neben einer Diagnosefunktion zur Abschätzung der Leistungsfähigkeit des Bordnetzes und Ansteuerung der Feststellbremse 5,6,7,11,12 verschiedene andere Funktionen zur Fahrdynamikregelung, wie z.B. ESP (elektronisches Stabilitätsprogramm), ASR (Antriebsschlupfregelung), ABS (Antiblockiersystem), oder Funktionen zur Durchführung eines elektrischen Energie- und Verbrauchermanagements integriert sein können, ebenso wie die oben genannten Diagnosefunktionen.

Die Feststellbremse wird mittels des Bedienelements 7 vom Fahrer betätigt. Diesen Feststellbremswunsch erkennt das Steuergerät 6 und steuert entsprechend eine Hydraulikpumpe im Hydroaggregat 5 an, die in der Hydraulikleitung 9 Druck erzeugt, um die Bremsbacken 11 anzuziehen und die Verriegelungseinrichtung 12 zu betätigen.

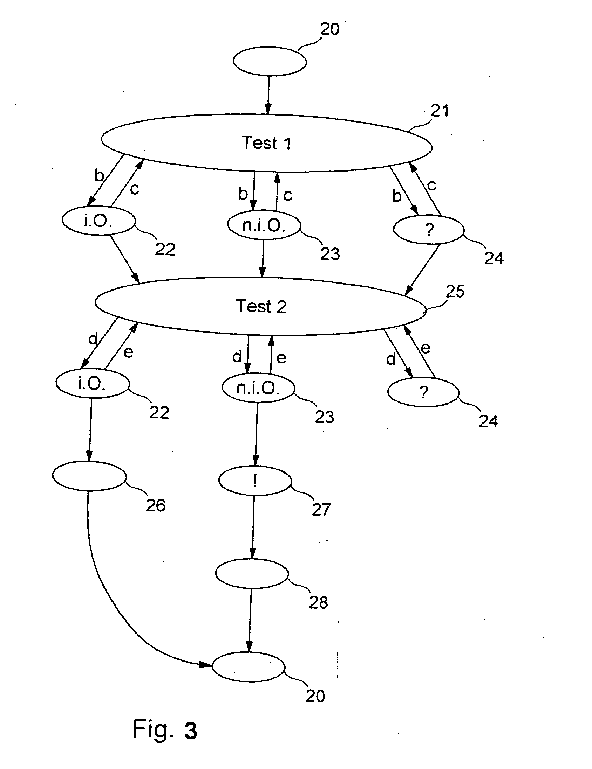

Zur Überwachung des Bordnetzes können verschiedene Maßnahmen getroffen werden, die im folgenden anhand von Fig. 3 beispielhaft näher erläutert werden.

Fig. 3 zeigt ein Zustandsdiagramm für verschiedene Betriebszustände.

Ausgehend vom Ruhezustand 20 (Zündung aus, Feststellbremse verriegelt) wird der Verbrennungsmotor des Fahrzeugs gestartet und die Feststellbremse 11,12 gelöst. Dabei steuert das Steuergerät 6 die Hydraulikpumpe 5 an, um zusätzlich Druck zum Entriegeln der Verriegelungseinrichtung 12 zu erzeugen. Im diesem Zustand kann die Leistungsfähigkeit des Bordnetzes abgeschätzt werden. Hierzu wird im Steuergerät 6 oder einer anderen geeigneten Elektronik überprüft (Zustand 21), ob die Bordnetzspannung U_{BN} beim Anlauf der Hydraulikpumpe unter einen vorgegebenen Schwellenwert sinkt. Unterschreitet die Bordnetzspannung U_{BN} den Schwellenwert, ist dies ein Indiz für eine schwache oder defekte Energieversorgung.

Sofern das Verhalten der Bordnetzspannung U_{BN} zu einem anderen Zeitpunkt überprüft werden soll, kann das Steuergerät 6 z.B. auch einen zusätzlichen Verbraucher 17 kurzfristig zuschalten und die Reaktion der Bordnetzspannung U_{BN} auswerten.

Aus diesem ersten Spannungstest können sich gemäß dem dargestellten Ausführungsbeispiel drei verschiedene Zustände 22,23 oder 24 ergeben. Der Zustand 22 (Bordnetz in Ordnung) stellt sich ein, wenn die Bordnetzspannung während des Spannungstests den Schwellenwert nicht unterschritten hat. Der Zustand 23 (Bordnetz schwach bzw. nicht in Ordnung) stellt sich ein, wenn die Schwellenspannung während des Spannungstest unterschritten wurde, und Zustand 24 (Leistungsfähigkeit undefiniert) stellt sich ein, wenn keine klare Aussage bezüglich der Leistungsfähigkeit getroffen werden konnte.

Im weiteren Fahrbetrieb des Fahrzeugs kann die Leistungsfähigkeit des Bordnetzes wiederholt anhand der Bordnetzspannung U_{BN} überprüft werden. Die erneute Überprüfung erfolgt vorzugsweise in Situationen, in denen große Verbraucher 17, wie z.B. die Hydraulikpumpe 5, zugeschaltet werden (Pfeile b,c).

Im Zustand 25 wird die Leistungsfähigkeit zusätzlich durch Auswertung der Spannungswelligkeit abgeschätzt. Bei hoher Spannungswelligkeit deutet dies auf eine defekte Batterie 8 hin und führt somit in den Zustand 23 (Bordnetz schwach). Eine geringe Spannungswelligkeit deutet auf ein einwandfrei funktionierendes Bordnetz hin und führt somit in den Zustand 22 (Bordnetz in Ordnung). Sofern keine eindeutige Aussage getroffen werden kann, führt dies in den Zustand 24. Die Auswertung der Spannungswelligkeit kann ebenfalls mehrfach wiederholt werden (Pfeile d,e). Die Anzahl kann vorgegeben werden.

Die Spannungswelligkeit kann bezüglich der Amplituden oder z.B. auch bezüglich der Frequenz ausgewertet werden.

Bei ordnungsgemäß funktionierendem Bordnetz (Zustand 22) wird die Feststellbremsfunktion auf Anforderung in bekannter Weise ausgeführt. D.h. das Steuergerät 6 steuert das Hydroaggregat 5 an und betätigt somit die Bremszangen und die Verriegelungseinrichtung 12 (Zustand 26). Bei sehr heißen Bremsen können die Bremszangen 11 auch zunächst nur angezogen werden, ohne sie zu verriegeln. Die Verriegelung erfolgt erst nach einer vorgegebenen Nachlaufzeit, nach der die Bremszangen nochmals angezogen werden.

Bei einem nicht ordnungsgemäß funktionierenden Bordnetz (Zustand 23) wird eine Warnmeldung an den Fahrer ausgegeben (Zustand 27). Gleichzeitig kann der Fahrer auch dazu aufgefordert werden, durch Betätigen des Fuß-Bremspedals 1 die Hydraulikpumpe zu unterstützen und ausreichenden Bremsdruck aufzubauen (Zustand 28). Sofern die Feststellbremse dadurch verriegelt werden kann, kann der Motor ausgestellt werden. Andernfalls muss der Fahrer aufgefordert werden, den Wagen in der Ebene abzustellen oder anderweitig gegen ungewolltes Wegrollen zu sichern. Der Betrieb der Feststellbremse geht dann wieder in den Ruhezustand 20 über.

Das vorstehend erläuterte Verfahren hat den wesentlichen Vorteil, dass die Leistungsfähigkeit des Bordnetzes ohne zusätzliche Sensorik, wie z.B. eine aufwändige Batteriezustandserkennung abgeschätzt werden kann.

### Bezugszeichenliste

- 1: Bremspedal
- 2: Bremskraftverstärker
- 3: Hauptbremszylinder
- 4: Umschaltventil
- 5: Hydroaggregat
- 6: Steuergerät
- 7: Bedienelement
- 8: Fahrzeugbatterie
- 9: Hydraulikleitung
- 10: Magnetventil
- 11: Radbremse
- 12: Verriegelungseinrichtung
- 13: Bremsscheiben
- 14: Bordnetz
- 15: Generator
- 16,17: Verbraucher
- 18: Schalter
- 20: Ruhezustand
- 21: Spannungstest
- 22: Bordnetz in Ordnung
- 23: Bordnetz schwach
- 24: unbestimmter Zustand des Bordnetzes
- 25: Welligkeitstest
- 26: Feststellbremsfunktion durchführen
- 27: Warnmeldung
- 28: Notverriegelung

## Patentansprüche

1. Verfahren zum Überprüfen der Leistungsfähigkeit eines elektrischen Bordnetzes (14), das von einem Generator (15) gespeist wird, wobei eine Elektronik (6) vorgesehen ist, die die Welligkeit der Bordnetzspannung (U_{BN}) auswertet, um die Leistungsfähigkeit des Bordnetzes (14) abzuschätzen und das Verhalten der Bordnetzspannung (U_{BN}) in Abhängigkeit von der Zuschaltung eines großen elektrischen Verbrauchers (5, 17) ausgewertet wird, wobei der große elektrischer Verbraucher (5, 17) vorübergehend zugeschaltet wird, **dadurch gekennzeichnet, dass** die Erkennung eines schwachen Bordnetzes dann erfolgt, wenn
die Auswertung des Spannungseinbruchs bei Zuschalten des großen elektrischen Verbrauchers (5, 17) ergibt, daß die Bordnetzspannung (U_{BN},) bei Zuschalten des großen elektrischen Verbrauchers (5, 17) unter einen vorgegebenen Schwellwert sinkt und
zusätzlich die Auswertung der Welligkeit der Bordnetzspannung (U_{BN}) anhand eines Schwellenwertvergleichs ein schwaches Bordnetz erkennen lässt, und
dass die Elektronik (6) bei erkanntem schwachem Bordnetz (14) eine Warnmeldung an den Fahrer ausgibt.

2. Verfahren zum Überwachen der Leistungsfähigkeit eines elektrischen Bordnetzes (14) nach Anspruch 1, **dadurch gekennzeichnet, dass** die Elektronik (6) die Leistungsfähigkeit des Bordnetzes (14) mehrere Male überprüft, bevor eine Warnmeldung ausgegeben wird.

3. Verfahren zum Überwachen der Leistungsfähigkeit eines elektrischen Bordnetzes (14) nach einem der vorhergehenden Ansprüche, **dadurch gekennzeichnet, dass** die Temperatur bei der Überprüfung der Leistungsfähigkeit des Bordnetzes (14) berücksichtigt wird.

4. Verfahren zum Überwachen der Leistungsfähigkeit eines elektrischen Bordnetzes (14) **dadurch gekennzeichnet, dass** es in einem Bremsen-Steuergerät abläuft, das Ansteuersignale für eine von einer im Bordnetz vorhandenen Batterie (8) versorgte Feststellbremse (5-12) abgibt und dass die Feststellbremse (5-12) derart eingerichtet ist, dass der Fahrer die Feststellbremse durch Betätigen der Fußbremse (1) unterstützen kann.

## Claims

1. Method for checking the performance of an on-board vehicle electrical system (14) which is fed by a generator (15), with an electronics system (6) being provided which evaluates the ripple of the on-board vehicle electrical system voltage (U_{BN}) in order to estimate the performance of the on-board vehicle electrical system (14), and the behaviour of the on-board vehicle electrical system voltage (U_{BN}) being evaluated as a function of a large electrical load (5, 17) being connected, with the large electrical load (5, 17) being temporarily connected, **characterized in that** a weak on-board vehicle electrical system is identified when the evaluation of the ripple of the on-board vehicle electrical system voltage (U_{BN}) additionally identifies a weak on-board vehicle electrical system on the basis of a threshold value comparison, and the evaluation of the voltage dip when the large electrical load (5, 17) is connected results in the on-board vehicle electrical system voltage (U_{BN}) falling below a predefined threshold value when the large electrical load (5, 17) is connected, and **in that** the electronics system (6) outputs a warning message to the driver when a weak on-board vehicle electrical system (14) is identified.

2. Method for monitoring the performance of an on-board vehicle electrical system (14) according to Claim 1, **characterized in that** the electronics system (6) checks the performance of the on-board vehicle electrical system (14) several times before a warning message is output.

3. Method for monitoring the performance of an on-board vehicle electrical system (14) according to either of the preceding claims, **characterized in that** the temperature is taken into account when checking the performance of the on-board vehicle electrical system (14).

4. Method for monitoring the performance of an on-board vehicle electrical system (14), **characterized in that** it runs in a brake controller which emits actuating signals for a parking brake (5-12) which is supplied with power by a battery (8) which is present in the on-board vehicle electrical system, and **in that** the parking brake (5-12) is designed in such a way that the driver can assist the parking brake by operating the foot brake (1).

## Revendications

1. Procédé pour contrôler la puissance disponible d'un réseau électrique embarqué (14) alimenté par un générateur (15), selon lequel il est prévu un circuit électronique (6) qui exploite l'ondulation de la tension du réseau embarqué (U_{BN}) pour évaluer la puissance disponible dans le réseau embarqué (14) et exploiter le comportement de la tension du réseau embarqué (U_{BN}) en fonction du branchement d'un consommateur électrique important (5, 17),
selon lequel on branche provisoirement le consommateur électrique important (5, 17),
**caractérisé en ce qu'**
on considère que le réseau embarqué est faible si
l'exploitation de l'effondrement de la tension lorsqu'on branche le consommateur électrique important (5, 17) entraîne une chue de la tension du réseau embarqué (U_{BN}) en dessous d'un seuil prédéfini lorsqu'on branche le consommateur électrique important (5, 17) et
en plus, l'exploitation de l'ondulation de la tension du réseau embarqué (U_{BN}) permet de déceler un réseau embarqué faible, par comparaison avec le seuil et
si un réseau embarqué faible (14) est constaté, le circuit électronique (6) émet un message d'avertissement pour le conducteur.

2. Procédé de surveillance de la puissance disponible dans un réseau électrique embarqué (14) selon la revendication 1,
**caractérisé en ce que**
le circuit électronique (6) vérifie la puissance disponible dans le réseau embarqué (14) plusieurs fois avant d'émettre un message d'avertissement.

3. Procédé de surveillance de la puissance disponible dans un circuit électrique embarqué (14) selon l'une des revendications précédentes,
**caractérisé en ce qu'**
on tient compte de la température lorsqu'on vérifie la puissance disponible dans le réseau embarqué (14).

4. Procédé de surveillance de la puissance disponible d'un réseau électrique embarqué (14),
**caractérisé en ce que**
le procédé est exécuté dans un appareil de commande de freins qui fournit des signaux de commande à un frein de stationnement (5-12) alimenté à partir de la batterie (8) du réseau embarqué,
le frein de stationnement (5-12) est conçu pour que le conducteur assiste le frein de stationnement en actionnant la pédale de frein (1).
